# EUROPÄISCHE PATENTSCHRIFT

(11) **EP 4 049 901 B1**
(45) Veröffentlichungstag und Bekanntmachung des Hinweises auf die Patenterteilung: **02.04.2025**
(21) Anmeldenummer: 22157959.2
(22) Anmeldetag: 22.02.2022
(51) Int. Cl.: B60R 16/023, B60R 16/02, H02G 3/22, H05K 5/06, H01B 17/30, H01R 13/52

(54) **STROMSCHIENE UND ANORDNUNG, DIE EINE SOLCHE STROMSCHIENE UMFASST**
BUSBAR AND ASSEMBLY COMPRISING SUCH A BUSBAR
BARRE OMNIBUS ET AGENCEMENT COMPRENANT UNE TELLE BARRE OMNIBUS

(30) Priorität: 26.02.2021 DE 102021104624
(43) Veröffentlichungstag der Anmeldung: 31.08.2022
(73) Patentinhaber: Carl Freudenberg KG, 69469 Weinheim (DE)
(72) Erfinder: Ratfisch, Rouven, 64579 Gernsheim (DE); Heldmann, Ralf, 69483 Wald-Michelbach (DE); Ziegler, Günter, 68259 Mannheim (DE); Clemens, Markus, 64385 Reichelsheim (DE); Mall, Jürgen, 40213 Düsseldorf (DE)

(56) Entgegenhaltungen:
- EP-A1- 0 944 101
- DE-A1- 102007 034 478
- DE-A1- 102010 043 773
- DE-A1- 102015 213 439
- DE-A1- 102017 113 992
- DE-A1- 102018 109 863

## Beschreibung

### Technisches Gebiet

Die Erfindung betrifft eine Stromschiene und eine Anordnung, die eine solche Stromschiene umfasst. Die Stromschiene umfasst einen Tragkörper aus einem zähharten Werkstoff und zumindest einen elektrischen Leiter, wobei der Leiter mit dem Tragkörper verbunden ist wobei der Tragkörper eine Dichtung aus einem gummielastischen Werkstoff umfasst, die den Leiter außenumfangsseitig mit einem ringförmigen Dichtbereich dichtend umschließt, wobei der Tragkörper einen Kern und einen kragenförmigen Befestigungsflansch umfasst und wobei der Kern außenumfangseitig von dem Befestigungsflansch umschlossen ist.

### Stand der Technik

Stromschienen sind allgemein bekannt und gelangen zum Beispiel im Bereich "E-Mobility" zur Anwendung. Stromschienen sind in vielfältigen Ausführungen bereits Stand der Technik.

Dabei ist jedoch zu beachten, dass die vorbekannten Stromschienen nur bei "trocknen" Schnittstellen der Stromübergabe verwendet werden.

Bei den vorbekannten Stromschienen ist der Leiter direkt in einen aus einem zähharten Kunststoff bestehenden Tragkörper eingebettet. Der Leiter wird vom Kunststoff des Tragkörpers unmittelbar anliegend umschlossen.

Dabei ist jedoch von Nachteil, dass der Übergang vom Leiter zum Tragkörper nicht dauerhaft dicht ist.

Das liegt primär daran, dass der aus einem zähharten Kunststoff bestehende Tragkörper und der Leiter voneinander abweichende Wärmeausdehnungskoeffizienten aufweisen, sich dadurch bei Temperaturwechseln unterschiedlich stark ausdehnen oder zusammenziehen und es deshalb im Übergangsbereich zwischen dem Tragkörper und dem Leiter häufig zu unerwünschten Undichtigkeiten kommt.

Ist die Schnittstelle der Stromübergabe, wie zuvor beschrieben, trocken, ist ein solcher Nachteil weniger gravierend.

Gelangt die vorbekannte Stromschiene jedoch in einer Umgebung mit einem flüssigen Medium zur Anwendung, sind derartige Undichtigkeiten nicht akzeptabel. Die Undichtigkeiten führen in einem solchen Fall dazu, dass eine unerwünschte Leckage zwischen dem Tragkörper und dem Leiter entsteht.

Eine Stromschiene, wie eingangs beschrieben, ist aus der DE 10 2015 213 439 A1 bekannt. Die elektrischen Leiter sind als Stecker ausgebildet und aus dem Kern des Tragkörpers nach außen geführt. Außerhalb des Tragkörpers ist jeder der elektrischen Leiter mit einer als Dichtelement ausgebildeten Ummantelung versehen, wobei jede Ummantelung den entsprechenden Leiter dichtend umschließt.

Auch aus der DE 10 2018 109 863 A1, der EP 0 944 101 A1, der DE 10 2007 034 478 A1 und der DE 10 2017 113 992 A1 ist jeweils eine Stromschiene bekannt, die einen Tragkörper aus einem zähharten Werkstoff und zumindest einen elektrischen Leiter umfasst, wobei der Leiter mit dem Tragkörper verbunden ist und wobei der Tragkörper eine Dichtung aus einem gummielastischen Werkstoff umfasst, die den Leiter außenumfangsseitig mit einem ringförmigen Dichtbereich dichtend umschließt.

Aus der DE 10 2010 043 773 A1 ist eine elektrische Durchführung für Hermetik-Verdichter bekannt, wobei die Durchführung einen elektrisch leitenden Anschlussstift und ein elektrisches Isolationselement umfasst, die in einer Gehäuseöffnung mittels eines Befestigungselements druckdicht verspannbar angeordnet sind. Der Anschlussstift und das Isolationselement sind stofflich durch Aufvulkanisieren miteinander verbunden.

### Darstellung der Erfindung

Der Erfindung liegt die Aufgabe zu Grunde, eine Stromschiene und eine Anordnung der eingangs genannten Art derart weiterzuentwickeln, dass die Stromschiene auch in einer Umgebung mit einem flüssigen Medium zur Anwendung gelangen und/oder Temperaturwechseln ausgesetzt sein kann und trotzdem gute Gebrauchseigenschaften während einer langen Gebrauchsdauer aufweist. Insbesondere soll der Übergangsbereich zwischen Tragkörper und Leiter auch dann dauerhaft dicht sein.

Diese Aufgabe wird erfindungsgemäß durch eine Stromschiene gemäß Anspruch 1 und eine Anordnung gemäß Anspruch 12 gelöst.

Auf vorteilhafte Ausgestaltungen nehmen die auf die zuvor genannten Ansprüche direkt oder indirekt rückbezogenen Ansprüche Bezug.

Zur Lösung der Aufgabe ist es vorgesehen, dass die Dichtung zusätzlich zum Dichtbereich einen Flanschbereich umfasst, der im Querschnitt betrachtet L-förmig und vom Befestigungsflansch in den Außenumfang des Kerns übergehend ausgebildet ist und den Kern in sich geschlossen dichtend umschließt.

Durch die dauerelastischen Eigenschaften des gummielastischen Werkstoffs der Dichtung ist der Übergangsbereich zwischen dem Tragkörper und dem Leiter stets dicht, unabhängig von Temperaturwechseln und unabhängig davon, ob die Stromschiene mit gasförmigen oder flüssigen Medien beaufschlagt ist.

Die voneinander abweichenden, unterschiedlichen Wärmeausdehnungskoeffizienten von Tragkörper und Leiter spielen auch bei den zuvor beschriebenen Umgebungsbedingungen der Stromschiene keine Rolle mehr. Unterschiedliche Wärmeausdehnungskoeffizienten werden durch die Dichtung stets funktional ausgeglichen. Die Gefahr einer Leckage im Übergangsbereich zwischen dem Tragkörper und dem Leiter besteht durch deren nur mittelbare Verbindung, nämlich die Verbindung mittels der Dichtung aus einem gummielastischen Werkstoff, nicht.

Die zuvor beschriebene Stromschiene ist besonders gut für die Verwendung im Bereich "E-Mobility" geeignet. In einem solchen Fall wird die Stromschiene in einem gekühlten Umfeld eingesetzt und mit einem speziellen Kohlenwasserstoff-Kühlmittel, das elektrisch nichtleitend ist, beaufschlagt.

Der Tragkörper umfasst einen Kern und einen kragenförmigen Befestigungsflansch, wobei der Kern außenumfangsseitig von dem Befestigungsflansch umschlossen ist. Durch eine solche Ausgestaltung lässt sich die Stromschiene mittels des Befestigungsflanschs gut an einem Maschinenelement, zum Beispiel an einem Gehäuse, befestigen. Die Stromschiene wird mittels des Befestigungsflanschs zum Beispiel über der Öffnung eines Gehäuses befestigt und verschließt die Öffnung dichtend.

Der Kern hat dabei eine größere Dicke als der Befestigungsflansch. Im Kern ist in einem solchen Fall der Schenkel des Leiters angeordnet, wobei der Kern von einem der Schenkel durchdrungen ist.

Im Befestigungsflansch können Befestigungs-/ Zentriermittel vorgesehen sein, um die Stromschiene auf dem Gehäuse zu befestigen und/oder zu zentrieren.

Die Dichtung umfasst zusätzlich zum Dichtbereich, der den Leiter außenumfangsseitig und ringförmig dichtend umschließt, einen Flanschbereich, der im Querschnitt betrachtet L-förmig und vom Befestigungsflansch in den Außenumfang des Kerns übergehend ausgebildet ist und den Kern in sich geschlossen dichtend umschließt. Der Flanschbereich der Dichtung dichtet zum Beispiel die zuvor beschriebene Öffnung des Gehäuses gegen die Umgebung des Gehäuses ab. Ein innerhalb des Gehäuses befindliches Medium wird dadurch innerhalb des Gehäuses gehalten und daran gehindert, unerwünscht in die Umgebung auszutreten.

Der Dichtbereich und der Flanschbereich sind bevorzugt einstückig ineinander übergehend und materialeinheitlich ausgebildet. Hierbei ist von Vorteil, dass der Dichtbereich und der Flanschbereich in einem Arbeitsgang gemeinsam mit dem Tragkörper verbunden werden. Dadurch ist die Herstellung der Stromschiene einfach und kostengünstig.

Der Tragkörper besteht bevorzugt aus einem polymeren Werkstoff. Hierbei ist von Vorteil, dass solche Tragkörper auch mit komplizierten Geometrien einfach und kostengünstig herstellbar sind. Außerdem ist von Vorteil, dass der Tragkörper elektrisch nichtleitend ist und deshalb im Bereich E-Mobilität besonders gut eingesetzt werden kann.

Die Dichtung kann aus einem elastomeren Werkstoff bestehen. Elastomere Werkstoffe für Dichtungen sind in einer großen Vielzahl mit einer Vielzahl voneinander abweichender Spezifikationen verfügbar. Die Anpassung an die jeweiligen Gegebenheiten des Anwendungsfalles sind dadurch besonders einfach möglich. Viele elastomere Dichtungswerkstoffe sind außerdem kostengünstig verfügbar.

Der Tragkörper und die Dichtung sind bevorzugt stoffschlüssig miteinander verbunden. Eine solche stoffschlüssige Verbindung kann dadurch hergestellt werden, dass der im Tragkörper positionierte Leiter mit elastomerem Werkstoff der Dichtung umspritzt wird, um eine dauerhaft dichtende Verbindung im Übergangsbereich zwischen Tragkörper und Leiter zu erzielen.

Davon abweichend besteht generell auch die Möglichkeit, zum Beispiel eine kraft- und/oder formschlüssige Verbindung vorzusehen. Eine solche Verbindung dauerhaft dicht zu halten, wäre jedoch nicht unproblematisch. Eine Vielzahl von Parametern müsste dabei berücksichtigt werden, beispielsweise die elastische Verpressung der Dichtung zwischen dem Tragkörper und dem Leiter.

Der Leiter kann als Kupfer-Metall-Teil ausgebildet sein. Ein solches Teil weist eine gute elektrische Leitfähigkeit auf.

Der Leiter kann als Stecker ausgebildet sein. Abhängig vom Anwendungsfall, in dem die Stromschiene zur Anwendung gelangt, können mehrere Leiter mit einem gemeinsamen Tragkörper verbunden sein. Es können zum Beispiel drei Leiter pro Tragkörper zur Anwendung gelangen.

Der Leiter kann, im Querschnitt betrachtet, im Wesentlichen L-förmig ausgebildet sein und einen ersten und einen zweiten Schenkel aufweisen. Solche L-förmigen Leiter sind einfach und kostengünstig herstellbar und einfach in einem Tragkörper anzuordnen.

Jeder der Schenkel des Leiters kann an den jeweils einander abgewandten freien Enden eine Kontaktierung aufweisen. Eine solche Kontaktierung kann beispielsweise durch eine Durchbrechung gebildet sein. In die Durchbrechung können zum Beispiel Stecker anderer elektrischer Leitungen eingesteckt oder in den Durchbrechungen mit dem jeweiligen Schenkel anders elektrisch kontaktiert werden.

Der Leiter kann den Tragkörper mit einem seiner Schenkel durchdringen. In einem solchen Fall durchdringt der eine Schenkel den Tragkörper und der andere Schenkel liegt, bevorzugt oberflächenbündig, auf der Oberfläche des Tragkörpers auf. Dadurch ist die Positionierung des den Tragkörper durchdringenden Schenkels besonders genau und einfach möglich.

Bei der gebrauchsfertigen Stromschiene stehen alle Schenkel von allen zur Anwendung gelangenden Leitern zum Beispiel gleich weit aus dem Tragkörper heraus.

Außerdem betrifft die Erfindung eine Anordnung, umfassend eine Stromschiene, wie zuvor beschrieben, und ein Gehäuse mit einer Öffnung, die von der Stromschiene dichtend verschlossen ist, wobei im Gehäuse ein abzudichtendes Medium angeordnet ist.

Das abzudichtende Medium kann durch ein flüssiges Medium, insbesondere ein Kühlmittel gebildet sein. Ein solches Kühlmittel ist zum Beispiel durch ein spezielles Kohlenwasserstoff-Kühlmittel gebildet, das im Bereich "E-Mobility" zur Anwendung gelangt.

### Kurzbeschreibung der Zeichnung

Ein Ausführungsbeispiel der erfindungsgemäßen Stromschiene und der erfindungsgemäßen Anordnung, in der die erfindungsgemäße Stromschiene zur Anwendung gelangt, werden nachfolgend anhand der Figuren 1 bis 3 näher beschrieben. Diese zeigen jeweils in schematischer Darstellung:
- Figur 1: einen perspektivischen Schnitt durch eine Stromschiene,
- Figur 2: einen vergrößerten Ausschnitt x aus Figur 1 und
- Figur 3: eine perspektivische Ansicht der Stromschiene aus Figur 1 von unten, aus Richtung eines abzudichtenden Gehäuses.

### Ausführung der Erfindung

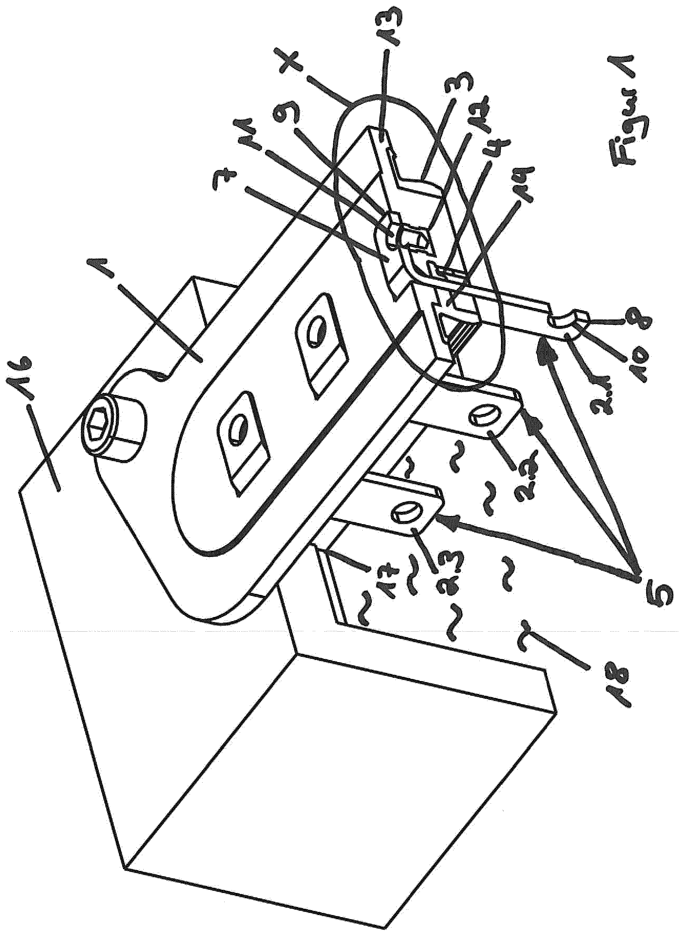

**In** Figur 1 ist ein Ausführungsbeispiel einer Stromschiene gezeigt. Die Stromschiene umfasst den Tragkörper 1 aus einem polymeren, zähharten Werkstoff und drei elektrische Leiter 2.1, 2.1, 2.3, die im Tragkörper 1 angeordnet sind.

Die Leiter 2.1, 2.2, 2.3 bestehen im gezeigten Ausführungsbeispiel jeweils aus einem Kupfer-Metall-Teil, wobei die Leiter 2.1, 2.2, 2.3 jeweils als Stecker 5 ausgebildet sind.

Die Stromübergabe erfolgt mittels der Leiter 2.1, 2.2., 2.3. Die Leiter 2.1, 2.2, 2.3 sind, wie hier gezeigt, im Wesentlichen L-förmig ausgebildet und weisen jeweils einen ersten 6 und einen zweiten Schenkel 7 auf, die einander im Wesentlichen rechtwinklig zugeordnet sind. Die freien Enden 8, 9 der Schenkel 6,7 weisen jeweils eine Kontaktierung 10, 11 auf, an die weitere elektrische Leiter zur Stromzu- oder -abfuhr anschließbar sind.

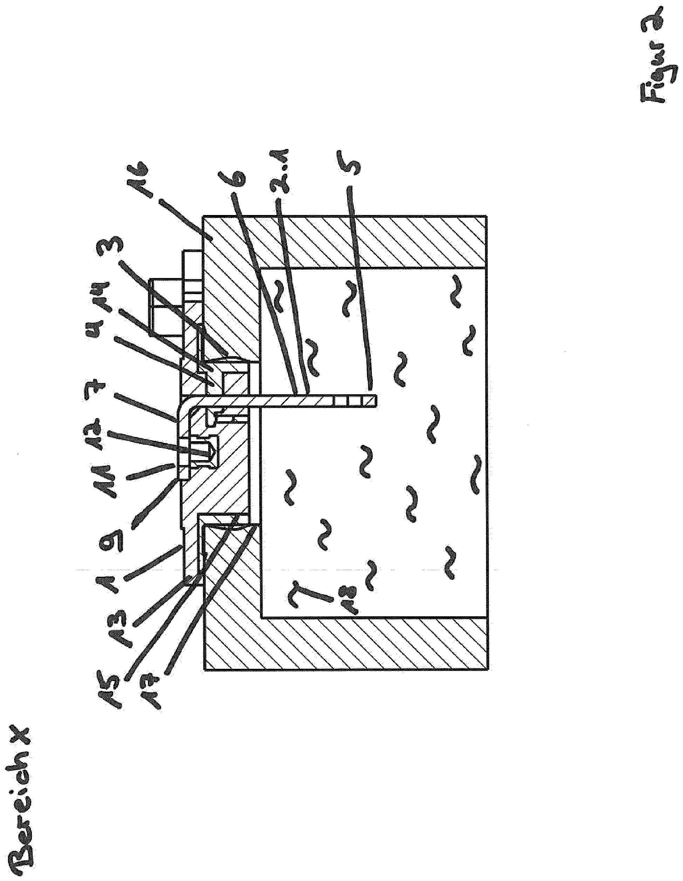

In den Figuren 1 und 2 ist außerdem ein Gehäuse 16 mit einer Öffnung 17 schematisch angedeutet, wobei die Öffnung 17 durch die erfindungsgemäße Stromschiene dichtend verschlossen ist. Innerhalb des Gehäuses 16 befindet sich ein flüssiges abzudichtendes Medium 18. Durch dieses Medium 18 sind die ersten Schenkel 6 der Stromschiene beaufschlagbar.

Um eine gute Abdichtung des Gehäuses 16 und insbesondere eine gute Abdichtung zwischen dem Tragkörper 1 und den Leitern 2.1, 2.2, 2.3 zu erzielen, ist zwischen dem Tragkörper 1 und den Leitern 2.1, 2.2, 2.3 die Dichtung 3 aus gummielastischen Werkstoff angeordnet, die die Leiter 2.1, 2.2, 2.3 außenumfangsseitig mit einem ringförmigen Dichtbereich 4 dichtend umschließt. Der Dichtbereich 4 bewirkt, dass im Übergangsbereich zwischen dem Tragkörper 1 und den Leitern 2.1, 2.2., 2.3 kein abzudichtendes Medium 18 vom Inneren des Gehäuses 16 an den Leiter 2.1, 2.2, 2.3 vorbei in die Umgebung der Stromschiene austreten kann.

Der ringförmige Dichtbereich 4 ist einstückig ineinander übergehend und materialeinheitlich mit dem Flanschbereich 14 ausgebildet, der ebenfalls von der Dichtung 3 umfasst ist. Der Flanschbereich 14 ist, im Querschnitt betrachtet, L-förmig ausgebildet.

Dadurch ist er an die Gestalt des Tragkörpers 1 mit Kern 12 und Befestigungsflansch 13 angepasst.

Der Tragkörper 1 umfasst den Kern 12, der außenumfangsseitig von dem kragenförmigen Befestigungsflansch 13 umschlossen ist. Dadurch, dass sich der Flanschbereich 14 außenumfangsseitig in sich geschlossen und dichtend um den Kern 12 erstreckt, ergibt sich die Gestalt des Flanschbereichs 14. Einer der Schenkel des Flanschbereichs 14 dichtet die Begrenzung der Öffnung 17 am Gehäuse 16 ab, der andere Schenkel demgegenüber die einander zugewandten Oberflächen von Gehäuse 16 und Befestigungsflansch 13.

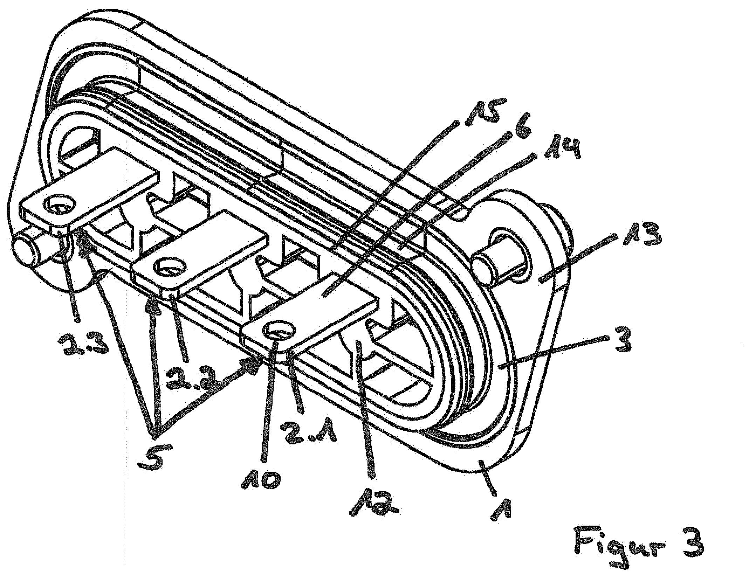

In Figur 3 ist die Stromschiene als Einzelteil in einer perspektivischen Ansicht von unten gezeigt. Die Leiter 2.1, 2.2, 2.3 durchdringen den Kern 12 des Tragkörpers 1 mit ihren Schenkeln 6, wobei die Schenkel 6 durch den hier nicht zu sehenden Dichtbereich 4 gegenüber dem Kern 12 abgedichtet sind. Der Flanschbereich 14 der Dichtung 3 umschließt den Kern 12 außenumfangsseitig in sich geschlossen und dichtend.

## Patentansprüche

1. Stromschiene, umfassend einen Tragkörper (1) aus einem zähharten Werkstoff und zumindest einen elektrischen Leiter (2.1, 2.2, 2.3, ...), wobei der Leiter (2.1, 2.2, 2.3, ...) mit dem Tragkörper (1) verbunden ist, wobei der Tragkörper (1) eine Dichtung (3) aus einem gummielastischen Werkstoff umfasst, die den Leiter (2.1, 2.2, 2.3, ...) außenumfangsseitig mit einem ringförmigen Dichtbereich (4) dichtend umschließt, wobei der Tragkörper (1) einen Kern (12) und einen kragenförmigen Befestigungsflansch (13) umfasst und wobei der Kern (12) außenumfangseitig von dem Befestigungsflansch (13) umschlossen ist, **dadurch gekennzeichnet, dass** die Dichtung (3) zusätzlich zum Dichtbereich (4) einen Flanschbereich (14) umfasst, der im Querschnitt betrachtet L-förmig und vom Befestigungsflansch (13) in den Außenumfang (15) des Kerns (12) übergehend ausgebildet ist und den Kern (12) in sich geschlossen dichtend umschließt.

2. Stromschiene nach Anspruch 1, **dadurch gekennzeichnet, dass** der Dichtbereich (4) und der Flanschbereich (14) einstückig ineinander übergehend und materialeinheitlich ausgebildet sind.

3. Stromschiene nach einem der Ansprüche 1 oder 2, **dadurch gekennzeichnet, dass** der Tragkörper (1) aus einem polymeren Werkstoff besteht.

4. Stromschiene nach einem der Ansprüche 1 oder 2, **dadurch gekennzeichnet, dass** die Dichtung (3) aus einem elastomeren Werkstoff besteht.

5. Stromschiene nach einem der Ansprüche 1 bis 4, **dadurch gekennzeichnet, dass** der Tragkörper (1) und die Dichtung (3) stoffschlüssig miteinander verbunden sind.

6. Stromschiene nach Anspruch 1, **dadurch gekennzeichnet, dass** der Leiter (2.1, 2.2, 2.3, ...) als Kupfer-Metall-Teil ausgebildet ist.

7. Stromschiene nach einem der Ansprüche 1 oder 6, **dadurch gekennzeichnet, dass** der Leiter (2.1, 2.2, 2.3, ...) als Stecker (5) ausgebildet ist.

8. Stromschiene nach einem der Ansprüche 1, 6 oder 7, **dadurch gekennzeichnet, dass** der Leiter (2.1, 2.2, 2.3, ...), im Querschnitt betrachtet, im wesentlichen L-förmig ausgebildet ist und einen ersten (6) und einen zweiten Schenkel (7) aufweist.

9. Stromschiene nach Anspruch 8, **dadurch gekennzeichnet, dass** jeder der Schenkel (6, 7) an den jeweils einander abgewandten freien Enden (8, 9) eine Kontaktierung (10, 11) aufweist.

10. Stromschiene nach einem der Ansprüche 1 oder 6 bis 9, **dadurch gekennzeichnet, dass** der Leiter (2.1, 2.2, 2.3, ...) den Tragkörper (1) mit einem der Schenkel (6) durchdringt.

11. Stromschiene nach einem der Ansprüche 1 bis 10, **dadurch gekennzeichnet, dass** der Kern (12) von dem Schenkel (6) durchdrungen ist.

12. Anordnung, umfassend eine Stromschiene nach einem der Ansprüche 1 bis 11 und ein Gehäuse (16) mit einer Öffnung (17), die von der Stromschiene dichten verschlossen ist, wobei im Gehäuse (16) ein abzudichtendes Medium (18) angeordnet ist.

13. Anordnung nach Anspruch 12, **dadurch gekennzeichnet, dass** das abzudichtende Medium (18) durch ein flüssiges Kühlmittel gebildet ist.

## Claims

1. Busbar comprising a supporting body (1) composed of a tough material and at least one electrical conductor (2.1, 2.2, 2.3, ...), wherein the conductor (2.1, 2.2, 2.3, ...) is connected to the supporting body (1), wherein the supporting body (1) comprises a seal (3) composed of a rubber-elastic material and sealingly surrounds the outer circumference of the conductor (2.1, 2.2, 2.3, ...) by way of an annular sealing region (4), wherein the supporting body (1) comprises a core (12) and a collar-like fastening flange (13), and wherein the outer circumference of the core (12) is surrounded by the fastening flange (13), **characterized in that** the seal (3) comprises, in addition to the sealing region (4), a flange region (14) which, as viewed in cross section, is L-shaped and is formed in a manner transitioning from the fastening flange (13) into the outer circumference (15) of the core (12) and sealingly surrounds the core (12) in an inherently closed manner.

2. Busbar according to Claim 1, **characterized in that** the sealing region (4) and the flange region (14) are formed in a manner transitioning integrally into one another and from the same material.

3. Busbar according to one of Claims 1 or 2, **characterized in that** the supporting body (1) consists of a polymeric material.

4. Busbar according to one of Claims 1 or 2, **characterized in that** the seal (3) consists of an elastomeric material.

5. Busbar according to one of Claims 1 to 4, **characterized in that** the supporting body (1) and the seal (3) are connected to each other in a cohesively bonded manner.

6. Busbar according to Claim 1, **characterized in that** the conductor (2.1, 2.2, 2.3, ...) is in the form of a copper-metal part.

7. Busbar according to one of Claims 1 or 6, **characterized in that** the conductor (2.1, 2.2, 2.3, ...) is in the form of a plug (5).

8. Busbar according to one of Claims 1, 6 or 7, **characterized in that** the conductor (2.1, 2.2, 2.3, ...), as viewed in cross section, is substantially L-shaped and has a first limb (6) and a second limb (7).

9. Busbar according to Claim 8, **characterized in that** each of the limbs (6, 7) has a contact-making means (10, 11) at the free ends (8, 9), which are averted from each other.

10. Busbar according to one of Claims 1 or 6 to 9, **characterized in that** the conductor (2.1, 2.2, 2.3, ...) penetrates the supporting body (1) by way of one of the limbs (6).

11. Busbar according to one of Claims 1 to 10, **characterized in that** the limb (6) penetrates the core (12).

12. Arrangement comprising a busbar according to one of Claims 1 to 11 and a housing (16) with an opening (17) which is sealingly closed by the busbar, wherein a medium (18) to be sealed off is arranged in the housing (16).

13. Arrangement according to Claim 12, **characterized in that** the medium (18) to be sealed off is formed by a liquid coolant.

## Revendications

1. Barre omnibus, comprenant un corps de support (1) en un matériau résistant et au moins un conducteur électrique (2.1, 2.2, 2.3,...), le conducteur (2.1, 2.2, 2.3,...) étant relié au corps de support (1), le corps de support (1) comprenant un joint d'étanchéité (3) en un matériau ayant l'élasticité du caoutchouc, qui, par une zone d'étanchéité annulaire (4), entoure de manière étanche le conducteur (2.1, 2.2, 2.3,...) du côté de la périphérie extérieure, le corps de support (1) comprenant un noyau (12) et une bride de fixation (13) en forme de collerette, et le noyau (12) étant entouré du côté de la périphérie extérieure par la bride de fixation (13), **caractérisée en ce que** le joint (3) comprend, en plus de la zone d'étanchéité (4), une zone de bride (14) qui, vue en coupe transversale, est réalisée en forme de L et s'étend depuis la bride de fixation (13) dans la périphérie extérieure (15) du noyau (12) et entoure le noyau (12) de manière étanche et fermée sur elle-même.

2. Barre omnibus selon la revendication 1, **caractérisée en ce que** la zone d'étanchéité (4) et la zone de bride (14) sont réalisées d'une seule pièce, en se fondant l'une dans l'autre et dans le même matériau.

3. Barre omnibus selon l'une des revendications 1 ou 2, **caractérisée en ce que** le corps de support (1) est constitué d'un matériau polymère.

4. Barre omnibus selon l'une des revendications 1 ou 2, **caractérisée en ce que** le joint d'étanchéité (3) est constitué d'un matériau élastomère.

5. Barre omnibus selon l'une des revendications 1 à 4, **caractérisée en ce que** le corps de support (1) et le joint d'étanchéité (3) sont reliés entre eux par une liaison de matière.

6. Barre omnibus selon la revendication 1, **caractérisée en ce que** le conducteur (2.1, 2.2, 2.3,...) est réalisé sous la forme d'une pièce cuivre-métal.

7. Barre omnibus selon l'une des revendications 1 ou 6, **caractérisée en ce que** le conducteur (2.1, 2.2, 2.3,...) est réalisé sous la forme d'un connecteur (5).

8. Barre omnibus selon l'une des revendications 1, 6 ou 7, **caractérisée en ce que** le conducteur (2.1, 2.2, 2.3, ...), vu en coupe transversale, est sensiblement en forme de L et présente une première (6) et une deuxième branche (7).

9. Barre omnibus selon la revendication 8, **caractérisée en ce que** chacune des branches (6, 7) présente une partie de contact (10, 11) aux extrémités libres (8, 9) respectivement opposées l'une à l'autre.

10. Barre omnibus selon l'une des revendications 1 ou 6 à 9, **caractérisée en ce que** le conducteur (2.1, 2.2, 2.3,...) traverse le corps de support (1) par l'une des branches (6).

11. Barre omnibus selon l'une des revendications 1 à 10, **caractérisée en ce que** le noyau (12) est traversé par la branche (6).

12. Agencement comprenant une barre omnibus selon l'une des revendications 1 à 11 et un boîtier (16) avec une ouverture (17) qui est fermée de manière étanche par la barre conductrice, un milieu d'étanchéification (18) étant placé dans le boîtier (16).

13. Agencement selon la revendication 12, **caractérisée en ce que** le milieu d'étanchéification (18) est formé par un agent réfrigérant liquide.
